(19) Europäisches Patentamt
European Patent Office
Office européen des brevets

(11) Numéro de publication: **0 186 534**
**A1**

(12) # DEMANDE DE BREVET EUROPEEN

(21) Numéro de dépôt: **85402180.5**

(22) Date de dépôt: **12.11.85**

(51) Int. Cl.⁴: **H 01 L 41/22**
G 08 B 13/10, G 08 B 13/16

(30) Priorité: **16.11.84 FR 8417558**

(43) Date de publication de la demande:
**02.07.86 Bulletin 86/27**

(84) Etats contractants désignés:
**DE GB NL**

(71) Demandeur: **THOMSON-CSF**
**173, Boulevard Haussmann**
**F-75379 Paris Cedex 08(FR)**

(72) Inventeur: **Micheron, François**
**THOMSON-CSF SCPI 173, bld Haussmann**
**F-75379 Paris Cedex 08(FR)**

(74) Mandataire: **Lepercque, Jean et al,**
**THOMSON-CSF SCPI 19, avenue de Messine**
**F-75008 Paris(FR)**

(54) **Procédé de fabrication d'un capteur linéaire de pression.**

(57) L'invention se rapporte au domaine des capteurs linéaires de pression et en particulier à ceux utilisant les propriétés piézoélectriques d'un matériau électrique.

L'invention a pour objet un procédé de fabrication d'un tel capteur formé d'un ou de plusieurs éléments transducteurs (1, 2) constitués de plusieurs tronçons associés de façon à pouvoir localiser au moyen d'un circuit de traitement (3, 4, 5, 6) délivrant des signaux codés, la partie du capteur qui a été sollicitée.

Le procédé de l'invention prévoit des étapes de polarisation à température ambiante de certains tronçons suivies d'étapes de maintien à basse température (−100°C par exemple) de la polarisation, ainsi que d'étapes de dépolarisation par un champ alternatif décroissant à température ambiante.

Application au contrôle du trafic routier, à la localisation de défaults dans la surveillance des ouvrages d'art par émission acoustique, etc ...

FIG_3

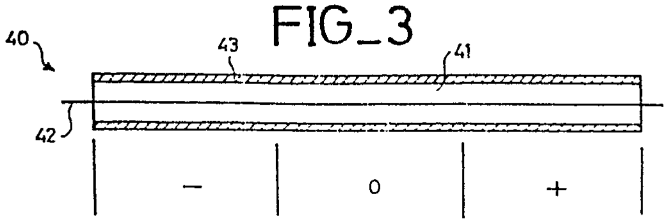




Croydon Printing Company Ltd

# PROCEDE DE FABRICATION D'UN CAPTEUR LINEAIRE DE PRESSION

La présente invention se rapporte au domaine des capteurs linéaires de pression et en particulier à ceux utilisant les propriétés piézoélectriques d'un matériau diélectrique.

Des capteurs linéaires de pression ont été réalisés avec succès par la mise en oeuvre dans un câble coaxial d'un diélectrique susceptible d'acquérir des propriétés piézoélectriques par la seule application d'un champ électrique d'amplitude supérieure à un champ de seuil. Cet effet a été notamment utilisé dans le brevet français de la Demanderesse portant le numéro de publication 2 458 827. De tels diélectriques appartiennent par exemple à la famille des copolymères du fluorure de vinylidène ($VF_2$) avec le tétrafluoroéthylène (TFE) ou le trifluoroéthylène (TrFE). Les alliages de ces copolymères avec le polyméthylmétacrylate (PMMA) entrent de même dans cette catégorie. Bien que présentant des propriétés piézoélectriques plus faibles les polyamides (6, 6-6, 6-10, 11, 12), par exemple le

polyamide 6 $\left[\overset{H}{\overset{|}{-N}} - (CH_2)_5 - \underset{\overset{\|}{O}}{C} - O\right]_n$ peuvent aussi être utilisés.

De tels capteurs sont capables de détecter l'amplitude et les caractéristiques temporelles d'une pression appliquée localement mais sont incapables d'en donner la localisation. Ainsi, un câble piézoélectrique peut être utilisé pour la détection d'intrus cherchant à pénétrer dans un certain périmètre. Le câble peut être alors enterré autour de ce périmètre. Il détectera effectivement une intrusion dans le périmètre mais il ne pourra pas en préciser le lieu. Le même problème se pose pour le contrôle du trafic routier, par exemple pour déterminer quelle voie d'une autoroute a été utilisée par un véhicule compté, pour la localisation de défauts dans la surveillance des ouvrages d'art par émission acoustique, etc.

Il est connu d'utiliser un capteur de pression comprenant un ou plusieurs éléments transducteurs, par exemple un câble multifilaire dans lequel tous les câbles élémentaires sont susceptibles de présenter une réponse électrique à une pression exercée. La réponse électrique positive, négative ou nulle de chacun des câbles élémentaires est répartie suivant leur longueur selon un code choisi à l'avance. Une pression exercée sur une section du câble multifilaire engendre aux extrémités des câbles des impulsions électriques en parallèle formant un mot codé représentatif de la section ayant subi la pression. Les matériaux piézoélectriques se prêtent particulièrement bien à la réalisation de tels capteurs de pression.

Pour réaliser un transducteur d'un tel capteur de pression, il est connu d'utiliser un procédé de polarisation consistant à effectuer la polarisation avant la mise en place de l'électrode externe. Ce procédé est illustré par la figure 5. Un câble 50 est constitué d'une âme conductrice 51 enduite, par exemple par extrusion, de polymère piézoélectrique 52. L'âme 51 est porté au potentiel de la masse. Le câble 50 passe à travers une filière conductrice 53 (en métal, en carbone ou en polymère graphité) portée au potentiel de polarisation désiré grâce à un générateur de tension 54. La polarisation peut se faire de façon discontinue, la filière 53 ayant la longueur du tronçon à polariser. Les conditions de polarisation sont sensiblement les suivantes : champ électrique appliqué supérieur ou égal à 400 KV/cm, pendant une minute à la température ambiante. La polarisation peut également être réalisée de manière continue, la longueur de la filière et la vitesse de déplacement étant réglées de façon à ce que chaque élément de tronçon à polariser voit la polarisation pendant le même temps. Si le câble est multifilaire, les câbles élémentaires peuvent être polarisés simultanément par l'utilisation d'autant de générateurs de tension programmés et synchrones.

La mise en place de l'électrode externe est réalisée de la même façon que pour tout autre câble coaxial. Il peut être utile néanmoins que les différents tronçons soient repérés (au moyen de couleurs, d'espacements dans la tresse, etc...). En effet, l'assemblage des différents câbles élémentaires dans la gaine isolante externe nécessite la coïncidence spatiale des tronçons de câbles élémentaires.

Le procédé de l'invention permet d'éviter ces inconvénients de réalisation.

C'est pourquoi l'invention concerne un procédé de fabrication d'un capteur linéaire de pression comprenant un élément transducteur convertissant une pression en une grandeur électrique, cet élément ayant une structure allongée composée d'un matériau piézoélectrique présentant un comportement ferroélectrique vrai et placé entre des électrodes, et étant formé de n tronçons à polarisations différentes, caractérisé en ce que le procédé pour obtenir l'élément transducteur est mis en oeuvre à partir de l'élément déjà muni de ses électrodes et en ce qu'il comporte les étapes suivantes :

- polarisation, à une température égale ou supérieure à la température ambiante, sous un premier champ électrique, par application d'un premier niveau de tension auxdites électrodes, d'au moins un desdits n tronçons ;
- maintien à une basse température, durant toute la suite du procédé, parmi les tronçons polarisés précédemment de ceux qui doivent conserver leur polarisation ;
- dépolarisation, par application à température ambiante, auxdites électrodes, d'une tension alternative décroissante dont l'amplitude maximale est suffisante pour dépolariser les tronçons à température ambiante mais insuffisante pour dépolariser les tronçons à basse température, et dont l'amplitude minimale tend vers zéro ;
- maintien à ladite basse température, durant toute la suite du procédé parmi les tronçons dépolarisés de ceux qui doivent conserver l'état de dépolarisation ;
- polarisation à une température égale ou supérieure à la température ambiante, sous un deuxième champ électrique, par application d'un deuxième niveau de tension auxdites électrodes, de tout ou partie des tronçons non maintenus à ladite basse température ;
- maintien à ladite basse température des tronçons dont on veut

maintenir l'état de polarisation ou de dépolarisation dans lequel il se trouve ;

- polarisation d'autres tronçons dans des états de polarisation distincts, à l'aide d'étapes de polarisations successives suivies chacune d'une étape de maintien à ladite basse température et d'une étape de dépolarisation, chaque étape de polarisation se faisant à une température égale ou supérieure à la température ambiante, sous un champ électrique particulier, par application, auxdites électrodes, d'un niveau de tension particulier.

L'invention sera mieux comprise et d'autres avantages apparaîtront au moyen de la description qui va suivre et des figures annexées parmi lesquelles :

- la figure 1 est explicative du fonctionnement d'un capteur selon l'art connu ;
- la figure 2 est un diagramme représentant un cycle d'hystérésis ;
- la figure 3 est une vue en coupe d'un câble comprenant trois tronçons de polarisation différente ;
- la figure 4 est un diagramme représentant une tension alternative d'amplitude décroissante en fonction du temps ;
- la figure 5 est illustrative d'un procédé de polarisation de type connu.

L'invention s'applique à tout élément transducteur capable de générer un signal électrique en réponse à une pression exercée en un point quelconque de ce transducteur, celui-ci étant constitué d'un matériau piéeoélectrique placé entre deux électrodes tels que ceux déjà cités. Il est alors avantageux d'utiliser comme élément transducteur un câble coaxial.

Dans le cas où on utilise un matériau piézoélectrique, la localisation de la pression exercée sur le capteur est obtenue par polarisation hétérogène le long d'un câble ou de plusieurs câbles qui sont solidaires mécaniquement. Le cas le plus simple est celui d'un câble unique, dont par exemple la moitié est polarisée de façon à fournir une tension positive sous l'effet d'une compression (polarisation +), et l'autre moitié polarisée en sens inverse (polarisation -) : le signe de l'impulsion en bout de câble permet de savoir quelle moitié a été sollicitée. Dans le cas général, le capteur sera constitué de plusieurs câbles coaxiaux rendus mécaniquement solidaire par moulage dans une gaine unique à l'intérieur de laquelle ils peuvent être torsadés.

La figure 1 est une figure explicative du fonctionnement d'un capteur de pression à deux câbles ou éléments transducteurs. Les câbles 1 et 2 sont des câbles coaxiaux. Le câble 1 possède une âme conductrice 11 noyée dans un matériau piézoélectrique 13 formant le corps du câble et recouvert d'une gaine conductrice 12. De même, le câble 2 possède une âme conductrice 21, un corps 23 en matériau piézoélectrique et une gaine conductrice 22. Les matériaux piézoélectriques sont réalisés en un polymère tel que ceux déjà cités. Chacun des câbles a été polarisé positivement (+), négativement (-) ou n'a pas été polarisé (0) selon des tronçons d'égales longueurs de sorte que les polarisations forment dans chaque tronçon de câble contigü des combinaisons différentes. Dans le cas d'un capteur à 2 câbles, il existe $3^2$ combinaisons possibles auxquelles il faut retirer la combinaison 0-0 qui ne donne pas de signal représentatif d'une pression exercée.

Chaque câble peut donc se décomposer en 8 tronçons. La répartition des polarisations le long des câbles doit être réalisée judicieusement afin d'exploiter toutes les possibilités de combinaisons. La figure 1 donne un exemple de répartition possible où les polarisations sont figurées par les signes +, -ou 0. A la détection, une impulsion positive est codée par le chiffre binaire 10, une impulsion négative par le chiffre binaire 01 et l'absence d'impulsion par le chiffre 00. Ce codage est obtenu par l'utilisation de deux comparateurs par câble disposés comme indiqué à la figure 1. Ces comparateurs référencés 3, 4, 5 et 6 répondent par une impulsion positive "1" lorsque la polarité de l'impulsion appliquée à l'entrée correspond à une tension positive et par l'absence d'impulsion "0" dans le cas contraire. On forme ainsi des chiffres de 1 à 4 bits, dont

la transcription décimale est affectée aux tronçons sollicités.

Le procédé selon l'invention permet la polarisation de câbles revêtus de leurs électrodes externes et même d'un capteur multifilaire complet. Ce procédé repose sur le fait que les matériaux piézoélectriques, tels que le copolymère de bifluorure de vinylidène et de trifluorure d'éthylène ($PVF_2$/PTrFE) a un comportement ferroélectrique vrai. Ceci a pour conséquence pratique que le champ électrique coercitif Ec est fortement dépendant de la température.

La figure 2 est un diagramme représentant des cycles d'hystérésis pour une composition du copolymère cité comprenant 70% de $PVF_2$ et 30% de PTrFE, en fonction de la température. L'axe des ordonnées représente la polarisation D en $mC/m^2$ ; l'axe des abscisses représente la valeur du champ électrique E en kV/cm. Les cycles d'hystérésis 30, 31, 32 et 33 ont été relevés pour des températures de respectivement 20°C, -20°C, -60°C et -100°C. On constate que le cycle d'hystérésis varie fortement avec la température. Ainsi le champ coercitif Ec est de l'ordre de 300 kV/cm à température ambiante et 1140 kV/cm à -100°C. Ceci implique que si le polymère polarisé est maintenu à basse température, celui-ci ne voit pas sa polarisation rémanente changer par application d'un champ électrique qui saturerait sa polarisation à température ambiante. En conséquence, le câble unique considéré ou le câble multifilaire dans son ensemble peuvent être polarisés de façon hétérogène. L'électrode externe étant au potentiel zéro et la tension de polarisation étant appliquée sur l'âme du câble, l'opération de polarisation du tronçon considéré s'effectue à une température égale ou supérieure à la température ambiante, les tronçons déjà polarisés étant maintenus à basse température.

La figure 3 est une vue en coupe d'un câble destiné à comprendre trois tronçons de polarisation différente : une valeur de polarisation négative pour le premier tronçon, nulle pour le second et positive pour le troisième. C'est ce qui est représenté sur la figure 3 où le câble 40 comprend une âme 42, un corps 41 formé par exemple d'un copolymère $PVF_2$/PTrFE et unbe électrode externe 43.

Le câble de la figure 3 est donné à titre d'exemple. Il ne comprend que trois tronçons mais ceux-ci suffisent à décrire toutes les variantes de polarisation. Pratiquement on peut réaliser la polarisation de la manière suivante.

Pour polariser négativement le premier tronçon, on peut appliquer entre l'âme 42 et l'électrode externe 43 un champ électrique négatif pour induire dans le corps 41 une polarisation rémanente de même signe. Un champ électrique supérieur ou égal à 400 KV/cm en valeur absolue, appliqué à température ambiante pendant une minute, donne de bons résultats. La longueur de câble correspondant au premier tronçon est alors portée à une température de l'ordre de -100°C, le reste du câble étant gardé à température ambiante. La polarisation du premier tronçon sera alors proche de la valeur à saturation. Pour annuler la polarisation, afin de réaliser le second tronçon, on peut appliquer entre l'électrode interne 42 et l'électrode externe 43 une tension alternative u d'amplitude décroissante jusqu' à zéro avec le temps t, comme représentée à la figure 4. Cette méthode de dépolarisation est identique à celle employée pour démagnétiser un matériau magnétique. Si la partie du câble laissée à température ambiante retrouve une polarisation nulle, le tronçon refroidi n'a pratiquement pas été affecté par la dépolarisation puisque ce tronçon avait une polarisation à saturation. L'amplitude maximale de la tension u (t) de la figure 4 doit bien sûr être suffisante pour réaliser la dépolarisation de la longueur de câble à température ambiante et insuffisante pour dépolariser le tronçon refroidi. Les deux premiers tronçons étant maintenus à basse température (-100°C), on peut polariser positivement le dernier tronçon par application d'un champ électrique positif supérieur ou égal à 400 kV/cm pendant une minute à température ambiante. Les deux premiers tronçons ne sont pratiquement pas affectés par la polarisation du troisième. La polarisation du second tronçon n'est plus tout à fait nulle. On peut remédier à cela en appliquant au câble une impulsion dépolarisante du type représenté à la figure 4, d'amplitude maximale juste suffisante pour annuler le

résidu de polarisation du second tronçon sans affecter la polarisation des premier et troisième tronçons. Dans ce cas, le câble dans son entier est maintenu à la même température, par exemple la température ambiante.

Il est possible d'obtenir de cette façon un câble formé d'un grand nombre de tronçons de polarisation différentes (positive, négative ou nulle). Il est clair que les tronçons situés en amont du tronçon en cours de polarisation passent par des états successifs de polarisation. Ceci n'a aucune importance étant donné que la polarisation rémanente définitive est celle imposée à la dernière opération de polarisation à température ambiante.

Le maintien des tronçons polarisés à une basse température (-100°C par exemple) se fait dans une chambre à basse température fonctionnant par exemple avec de l'azote liquide.

Le procédé de polarisation de l'invention a pour avantage qu'un câble multifilaire peut être polarisé au cours de la même opération pourvu que l'on dispose d'autant de générateurs de polarisation que de câbles élémentaires.

L'invention peut s'appliquer notamment au contrôle du trafic routier et à la localisation de défauts dans la surveillance des ouvrages d'art par émission acoustique.

## REVENDICATIONS

1. Procédé de fabrication d'un capteur linéaire de pression comprenant un élément transducteur (1, 2) convertissant une pression en une grandeur électrique, cet élément ayant une structure allongée composée d'un matériau piézoélectrique (13, 23) présentant un comportement ferroélectrique vrai et placé entre des électrodes (11, 12 ; 21, 22), et étant formé de n tronçons à polarisation différentes, caractérisé en ce que le procédé pour obtenir l'élément transducteur est mis en oeuvre à partir de l'élément déjà muni de ses électrodes et en ce qu'il comporte les étapes suivantes :

- polarisation, à une température égale ou supérieure à la température ambiante, sous un premier champ électrique, par application d'un premier niveau de tension auxdites électrodes, d'au moins un desdits n tronçons ;
- maintien à une basse température, durant toute la suite du procédé, parmi les tronçons polarisés précédemment de ceux qui doivent conserver leur polarisation ;
- dépolarisation, par application à température ambiante, auxdites électrodes, d'une tension alternative décroissante dont l'amplitude maximale est suffisante pour dépolariser les tronçons à température ambiante mais insuffisante pour dépolariser les tronçons à basse température, et dont l'amplitude minimale tend vers zéro ;
- maintien à ladite basse température, durant toute la suite du procédé parmi les tronçons dépolarisés de ceux qui doivent conserver l'état de dépolarisation ;
- polarisation à une température égale ou supérieure à la température ambiante, sous un deuxième champ électrique, par application d'un deuxième niveau de tension auxdites électrodes, de tout ou partie des tronçons non maintenus à ladite basse température ;
- maintien à ladite basse température des tronçons dont on veut maintenir l'état de polarisation ou de dépolarisation dans lequel il se trouve ;
- polarisation d'autres tronçons dans des états de polarisation

distincts, à l'aide d'étapes de polarisations successives suivies chacune d'une étape de maintien à ladite basse température et d'une étape de dépolarisation, chaque étape de polarisation se faisant à une température égale ou supérieure à la température ambiante, sous un champ électrique particulier, par application, auxdites électrodes, d'un niveau de tension particulier.

2. Procédé selon la revendication 1, caractérisé en ce que le matériau piézoélectrique (13, 23) auquel est appliqué le procédé est un composé de polyfluorure de vinylidène (PVF2) et de polytrifluoroéthylène (PTrFE).

3. Procédé selon la revendication 2, caractérisé en ce que le matériau piézoélectrique (13, 23) est un composé à 70% de polyfluorure de vinylidène ($PVF_2$) et à 30% de polytrifluoroéthylène (PTrFE).

4. Procédé selon l'une des revendications 1 ou 2, caractérisé en ce que ladite basse température est située entre -50 et -150 degrés Celsius.

5. Procédé selon l'une des revendications 1 ou 2, caractérisé en ce que ladite température ambiante est située entre -20 degrés et +30 degrés Celsius.

6. Procédé selon la revendication 1, caractérisé en ce que les électrodes auxquelles sont appliqués lesdits niveaux de tension et ladite tension alternative sont réalisées :

- l'une des électrodes (12, 22), sous la forme d'une gaine conductrice entourant le matériau piézoélectrique,
- l'autre électrode (11, 21), sous la forme d'un conducteur noyé dans le matériau piézoélectrique (13, 23) et coaxial à la gaine conductrice (12, 22).

FIG_1

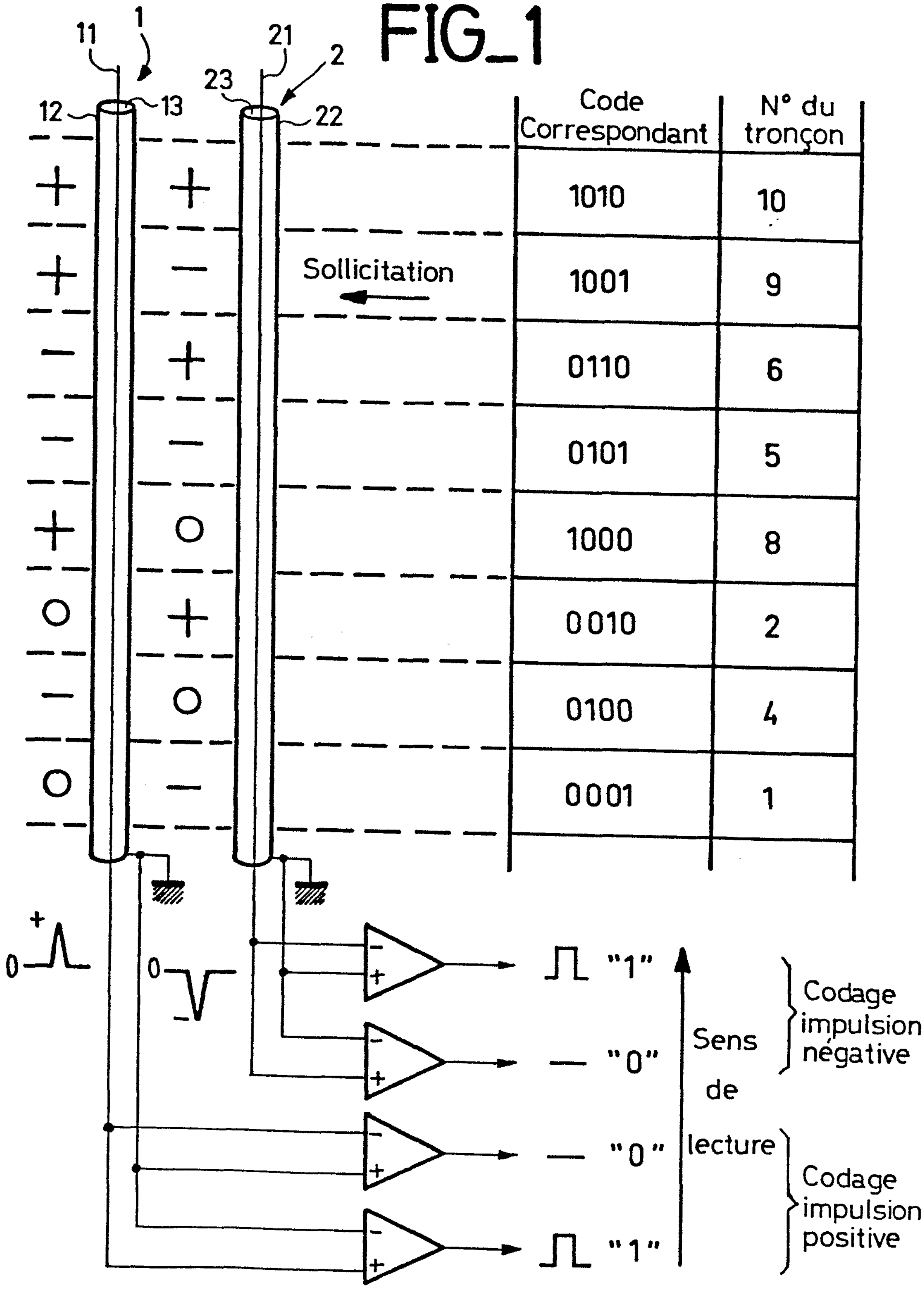

11
1
21
2
23
12
13
22
Code Correspondant
N° du tronçon
1010
10
Sollicitation
1001
9
0110
6
0101
5
1000
8
0010
2
0100
4
0001
1
"1"
"0"
"0"
"1"
Sens de lecture
Codage impulsion négative
Codage impulsion positive

FIG_2

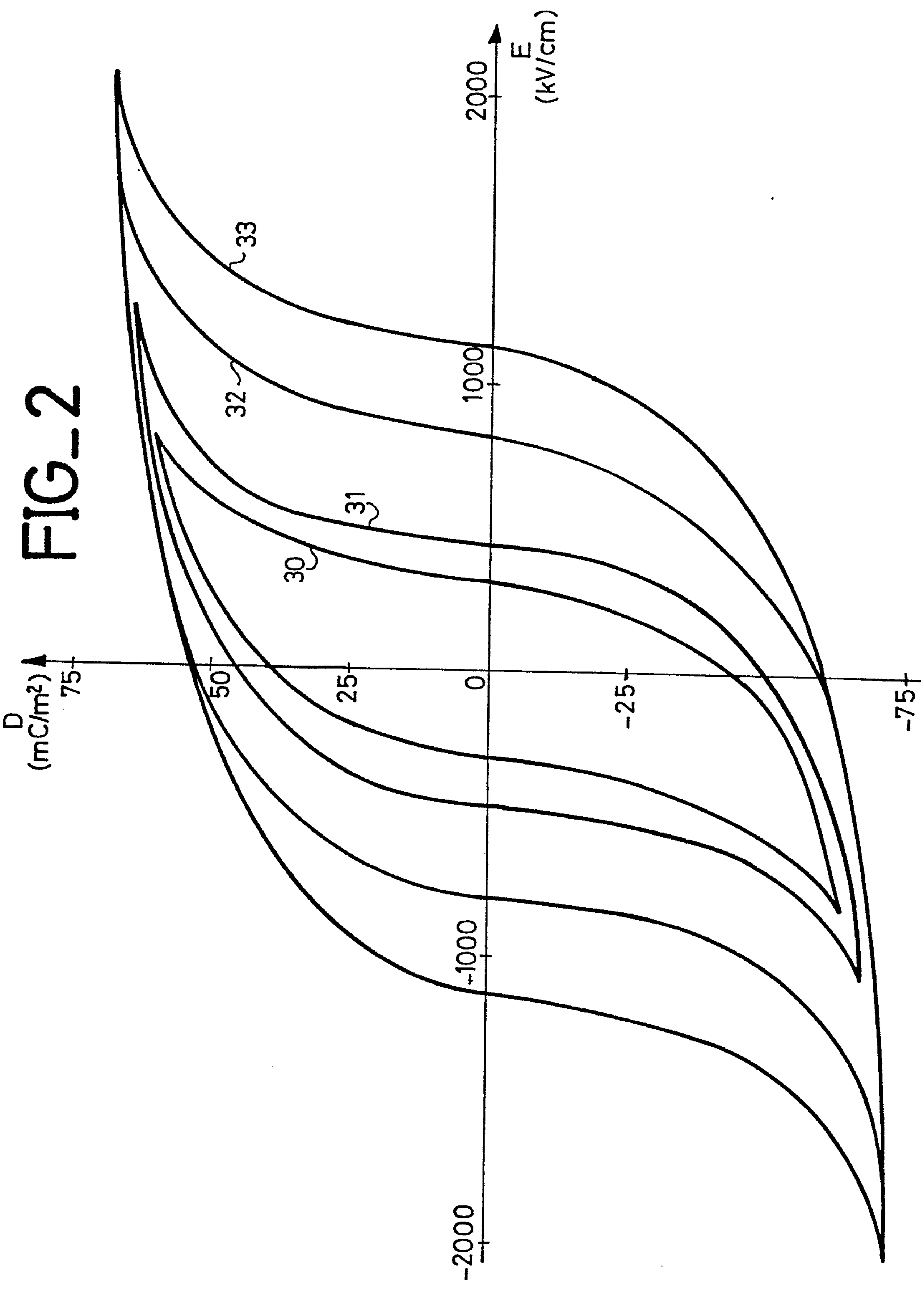

FIG_3

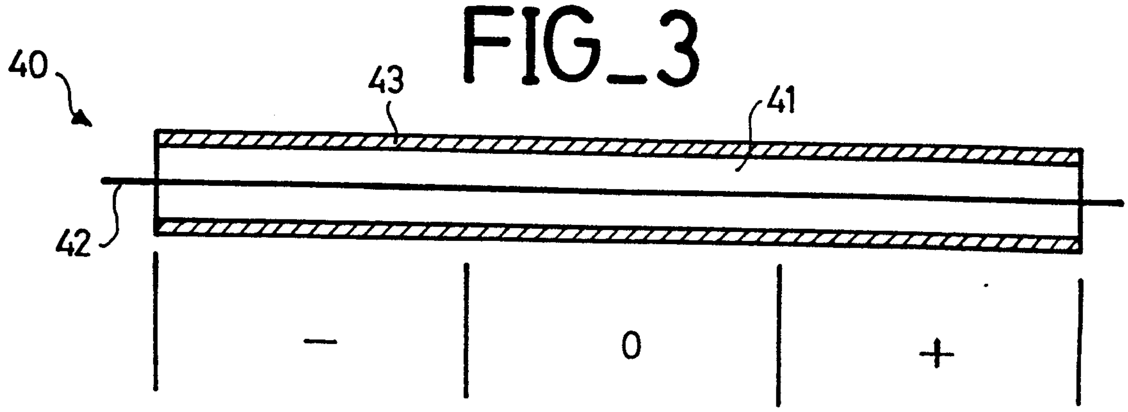


FIG_4

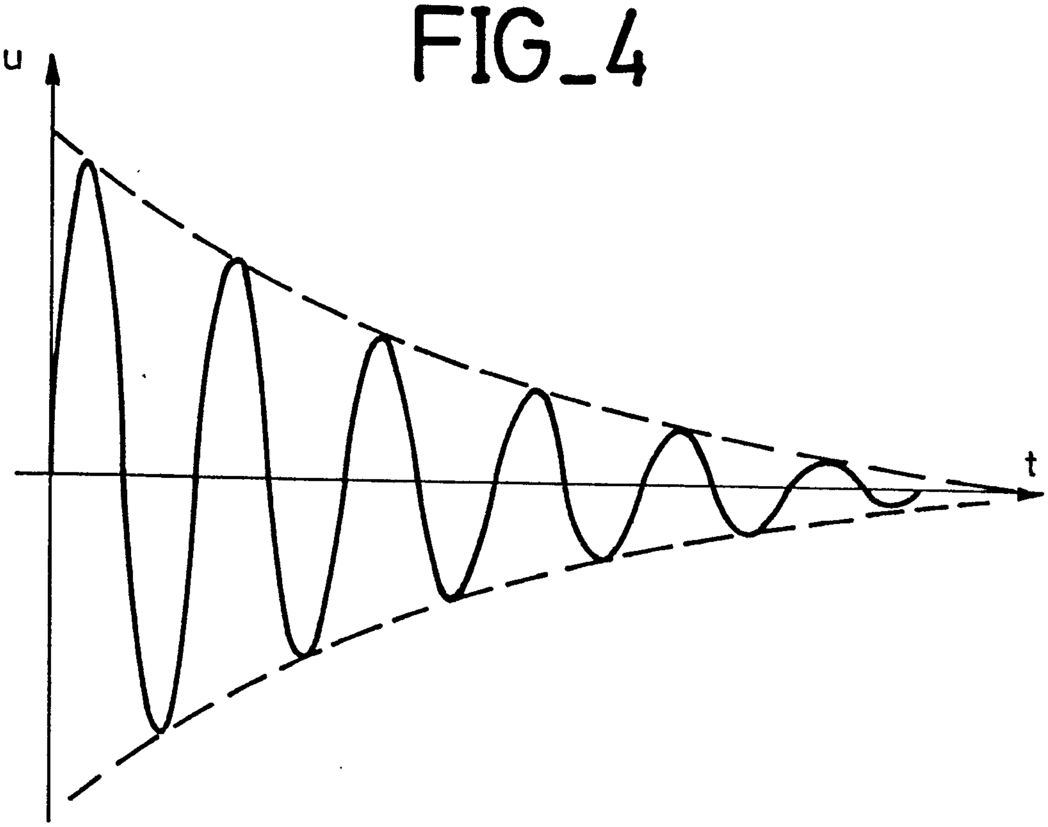


FIG_5

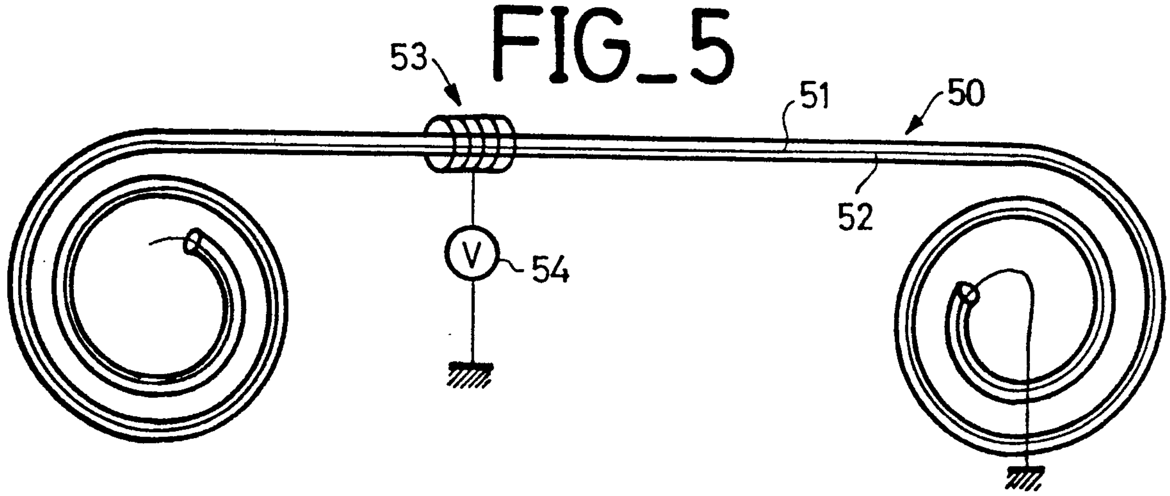

Office européen des brevets

# RAPPORT DE RECHERCHE EUROPEENNE

0186534
Numero de la demande

EP 85 40 2180

## DOCUMENTS CONSIDERES COMME PERTINENTS

| Catégorie | Citation du document avec indication, en cas de besoin des parties pertinentes | Revendication concernee | CLASSEMENT DE LA DEMANDE (Int Cl 4) |
|---|---|---|---|
| A | FR-A-2 519 503 (THOMSON-CSF) * En entier * | 1-6 | H 01 L 41/22<br>G 08 B 13/10<br>G 08 B 13/16 |
| A | FR-A-2 365 886 (PENNWALT CORP.) * Revendications * | 1-6 | |
| A | US-A-3 831 162 (ARMSTRONG) * Colonne 1, ligne 62 - colonne 5, ligne 56; figures * | 1 | |
| A | US-A-3 836 899 (DUVALL et al.) | | |

| DOMAINES TECHNIQUES RECHERCHES (Int Cl 4) |
|---|
| H 01 L<br>G 08 B |

Le present rapport de recherche a ete etabli pour toutes les revendications

| Lieu de la recherche | Date d achevement de la recherche | Examinateur |
|---|---|---|
| LA HAYE | 05-03-1986 | REEKMANS M.V. |

CATEGORIE DES DOCUMENTS CITES

X particulièrement pertinent à lui seul
Y particulièrement pertinent en combinaison avec un autre document de la même categorie
A arrière-plan technologique
O divulgation non-ecrite
P document intercalaire
T theorie ou principe à la base de l invention
E document de brevet anterieur mais publie a la date de depôt ou apres cette date
D cite dans la demande
L cite pour d autres raisons
& membre de la même famille, document correspondant

OEB Form 1503 03 82